(19) **Europäisches Patentamt**
**European Patent Office**
**Office européen des brevets**

(11) **EP 1 124 138 B1**

(12) **EUROPÄISCHE PATENTSCHRIFT**

(45) Veröffentlichungstag und Bekanntmachung des Hinweises auf die Patenterteilung:
**06.06.2007 Patentblatt 2007/23**

(51) Int Cl.:
*G01R 33/30* *(2006.01)*      *G01R 33/31* *(2006.01)*

(21) Anmeldenummer: **00127773.0**

(22) Anmeldetag: **19.12.2000**

(54) **Gekühlter NMR-Probenkopf mit thermischer Isolation der Messprobe**

Cooled NMR probe head with thermal isolation of the sample to be measured

Tête RMN réfrigérée avec isolation thermique de l'échantillon

(84) Benannte Vertragsstaaten:
**CH FR GB LI**

(30) Priorität: **12.02.2000 DE 10006317**

(43) Veröffentlichungstag der Anmeldung:
**16.08.2001 Patentblatt 2001/33**

(73) Patentinhaber: **Bruker BioSpin AG**
**8117 Fällanden (CH)**

(72) Erfinder: **Marek, Daniel**
**5103 Möriken (CH)**

(74) Vertreter: **Kohler Schmid Möbus**
**Patentanwälte**
**Ruppmannstrasse 27**
**70565 Stuttgart (DE)**

(56) Entgegenhaltungen:
US-A- 3 764 892      US-A- 4 587 492
US-A- 5 258 710      US-A- 5 508 613

• "METHOD FOR GENERATING SIGN SAMPLE TEMPERATURES IN A MAGNETIC RESONANCE PROBE" IBM TECHNICAL DISCLOSURE BULLETIN, IBM CORP. NEW YORK, US, Bd. 37, Nr. 4A, 1. April 1994 (1994-04-01), Seite 369 XP000446705 ISSN: 0018-8689

**Beschreibung**

Die Erfindung betrifft einen NMR(= Kernspinresonanz)-Probenkopf gemäß dem Oberbegriff von Anspruch 1.

Ein solcher gekühlter NMR-Probenkopf ist beispielsweise bekannt aus der US-A 5,247,256.

US-A-5 258 710 beschreibt einen HTS-Mikroskopiekopf. Die Empfangsspule befindet sich in einem mit Silber beschichteten Dewar.

In US-A-3 764 892 wird ein mit flüssigem Stickstoff gekühlter Strahlungsschild eines Spektrometers mit einer im Heliumtank des zugehörigen Magneten angeordneten HF-Spule beschrieben, der im Wesentlichen die auf die kalten Teile des Spektrometers einstrahlende Strahlungsleistung reduzieren soll.

US-A-5 508 613 offenbart einen NMR-Kryoprobenkopf mit einer gewöhnlichen Vakuumisolation zwischen dem Probenrohr und der HF-Spule. Darüber hinaus werden herkömmliche Strahlungsschilde zur Reduktion der Wärmeeinstrahlung auf die HF-Spule vorgeschlagen, deren Ort aber nicht näher spezifiziert wird.

US-A 4 587 492 beschreibt eine thermische Barriere aus Glasfasermatten zwischen dem HF-Bereich eines NMR-Probenkopfes mit variabler Temperatur und dem Spektrometermagneten.

Der beispielsweise in US-A 5,247,256 beschriebene Probenkopf wird in einem Magneten zum Erzeugen eines hochgradig homogenen, statischen $B_0$-Feldes eingebaut und enthält um eine z-Achse angeordnete HF-Empfangsspulen, welche mittels geeigneter Wärmetauscher und Wärmeleitungselemente im Betrieb bis auf Temperaturen von ca. 10 - 25 K abgekühlt werden, um bei der Messung das Signal-zu-Rausch-Verhältnis des empfangenen NMR-Signals zu verbessern. Die HF-Empfangsspulen befinden sich zum Zwecke der Wärmeisolation in einem evakuierten Raum, der im wesentlichen durch ein in der Regel metallisches Gehäuse des Probenkopfes gebildet wird, welches von einem um die z-Achse zylindrisch angeordneten Raumtemperaturrohr zur Aufnahme eines Probenröhrchens durchbrochen ist. Damit die HF-Signale von der Probe zu den HF-Empfangsspulen gelangen können, ist im axialen Bereich der Spulen das normalerweise ansonsten metallische Raumtemperaturrohr durch ein HF-durchlässiges Innenrohr, meist ein Glasrohr ersetzt, welches vakuumdicht an die metallischen Teile des Raumtemperaturrohres anschließt.

Zur Temperierung der Probensubstanz wird das Probenrohr nach dem Einführen in das Raumtemperaturrohr von unten her mittels eines warmen Luftstroms durch das Raumtemperaturrohr im wesentlichen auf einer gewünschten Temperatur (meist ca. 300 K) gehalten. Dabei tritt jedoch das Problem auf, daß die Meßprobe die ganz erheblich kühlere Umgebung des auf 10 - 25 K gekühlten NMR-Resonators "sieht" und dorthin ihre Wärme in radialer Richtung abstrahlt. Diese abgehende Wärme muß kontinuierlich vom aufsteigenden warmen Temperier-Luftstrom wieder zugeführt werden, damit die Meßprobe im wesentlichen auf der gewünschten Temperatur bleibt. Dieser Vorgang hat nun zur Folge, daß in der Meßprobe ein axialer und radialer Temperaturgradient entsteht, der die NMR-Messung stark stört.

Aufgabe der vorliegenden Erfindung ist es daher, einen gekühlten NMR-Probenkopf mit den eingangs genannten Merkmalen vorzustellen, bei dem der Temperaturgradient in z-Richtung im Betrieb wesentlich verringert ist, ohne daß die NMR-Messung dabei beeinträchtigt wird.

Erfindungsgemäß wird diese Aufgabe durch einen NMR-Probenkopf mit den Merkmalen des Patentanspruchs 1 gelöst.

Zu den erfindungsgemäßen NMR-Probenköpfen zählen neben denjenigen mit auswechselbaren Probenröhrchen auch sogenannte Durchflußköpfe, bei denen das Probenröhrchen fix eingebaut bleibt und die zu untersuchende Flüssigkeit durch eine dünne Leitung auf der einen Seite (unten) eingelassen wird und auf der anderen Seite (oben) hinausgeführt wird. Solche Probenköpfe können sowohl im kontinuierlichen Durchfluß wie auch im Flow- und Stop-Betrieb (für eine verlängerte Meßperiode) verwendet werden. Diese Probenköpfe werden einerseits für eine schnelle Sample-Einführung gebraucht, andererseits auch als eine sehr aussagekräftige Analysestufe, die einer Flüssig-Chromatographie Trennzelle nachgeschaltet wird. Im ersteren Fall spricht man von Durchflußprobenköpfen, im zweiten von LC-NMR Kopplung. Solche Probenköpfe werden auch als LC-Köpfe bezeichnet (Liquid Chromatography, im speziellen auch HPLC (High Pressure Liquid Chromatography). Derartige Probenköpfe können in besonderem Maße von der Kryo-Technologie und mithin von den erfindungsgemäßen Modifikationen profitieren.

In der Kryotechnik ist es zwar an sich seit langem bekannt, bei Wärmestrahlungsverlusten Strahlungsschilde einzusetzen, jedoch verbietet sich dieses Vorgehen zunächst im Falle eines gekühlten NMR-Probenkopfes, weil durch die in der Regel metallischen, Wärmestrahlung reflektierenden Strahlungsschilde eine Ausbreitung der HF-Felder von der Meßprobe zu den HF-Empfangsspulen ebenfalls entweder ganz abgeblockt oder zumindest stark behindert wird, so daß die ankommenden NMR-Signale zumindest extrem stark gedämpft, verzerrt oder überhaupt nicht mehr verwertbar wären.

Durch die erfindungsgemäße Lösung werden jedoch für die im Vakuum zwischen den HF-Spulen und dem Raumtemperaturrohr vorgesehenen Strahlungsschilde nur Materialien verwendet, welche einerseits in z-Richtung eine Ausrichtung besitzen. Die axiale Ausrichtung des Materials der Strahlungsschilde verhindert, daß deren endliche Suszeptibilität die Auflösung der NMR-Signale verschlechtert. Andererseits sollen die Materialien von ihren physikalischen Eigenschaften her im Bereich von Hochfrequenz-Strahlung möglichst transparent sein. Meistens muß die letztgenannte Materialeigenschaft aber damit erkauft werden, daß keine allzu hohe Rückreflektion der Verlustwärme zur Meßprobe hin erwartet werden kann.

Besonders bevorzugt ist eine Ausführungsform des erfindungsgemäßen NMR-Probenkopfes, bei der zwischen dem HF-Empfangsspulensystem und dem Raumtemperaturrohr N Strahlungsschilde in radialer Aufeinanderfolge angeordnet sind, wobei $N \geq 2$, vorzugsweise $5 \leq N < 25$. Durch die erfindungsgemäß vorgesehene Vielzahl von radial hintereinander angeordneten Strahlungsschilden kann, wie weiter unten im Einzelnen gezeigt wird, sogar bei Materialien, welche für Wärmestrahlung überhaupt keine Reflektivität aufweisen (also "schwarz" sind) eine deutliche Strahlungsbarriere aufgebaut werden, die eine erhebliche Reduktion der von der Meßprobe abgehenden Verlustwärme bewirkt. Andererseits ist der zur Verfügung stehende Raum im Vakuum zwischen dem HF-Empfangsspulensystem und der Vakuumseite des Raumtemperaturrohres recht begrenzt, so daß sich in der Praxis die Anzahl N der in radialer Abfolge einsetzbaren Strahlungsschilde in Grenzen hält.

Vorteilhaft ist es, wenn in radialer Richtung wenigstens ein minimaler Abstand zwischen den N Strahlungsschilden voneinander vorhanden ist und sich die Strahlungsschilde nicht oder zumindest nur punktuell bzw. linienförmig berühren, damit keine direkte Wärmeleitung zwischen den einzelnen Strahlungsschilden in radialer Richtung entsteht, die zu einem thermischen "Kurzschluß" führen würde. Allerdings stellt auch ein gelegentliches Berühren der Strahlungsschilde kein ernstliches Problem dar, insbesondere wenn ein Material gewählt wird, welches ohnehin eine sehr niedrige Wärmeleitung aufweist. So lange die einzelnen Berühungspunkte bzw. -linien genügend weit auseinanderliegen, ist die gesamte Wärmeleitung zwischen den radial angeordneten Strahlungsschilden für die erfindungsgemäßen Zwecke im wesentlichen vernachlässigbar.

Da der Abstand zwischen dem HF-Empfangsspulensystem und der Meßprobe möglichst nicht vergrößert werden soll, um die Empfindlichkeit der NMR-Messungen nicht zu verringern, sollten die einzelnen Strahlungsschilde möglichst dünn gewählt werden. Daher sollten die Strahlungsschilde eine radiale Dicke < 0,1mm, vorzugsweise < $50 \mu m$ aufweisen.

Besonders bevorzugt ist eine Ausführungsform des erfindungsgemäßen NMR-Probenkopfes, bei der die Strahlungsschilde aus Material aufgebaut sind, welches Strahlung in einem Wellenlängenbereich $10 \mu m \leq \lambda \leq 100 \mu m$ reflektiert oder zumindest absorbiert, und welches für Strahlung in einem Wellenlängenbereich $\lambda > 100mm$ transparent ist. Der erstgenannte Wellenlängenbereich entspricht Wärmestrahlung auf einer Temperatur zwischen ca. 20 K bis 300 K, was der Temperaturdifferenz zwischen der Meßprobe und den gekühlten NMR-Spulen gleichkommt, während der zweite Wellenlängenbereich einer Strahlung mit einer Frequenz unterhalb von 3 GHz entspricht, wobei der für die NMR-Messungen wichtige HF-Bereich zwischen einigen MHz unter etwa 1GHz liegt.

Ein optimales Material, welches praktisch keine Absorptionsverluste im betrachteten HF-Bereich aufweist, andererseits aber für den obengenannten Wärmestrahlungsbereich nicht transparent ist, ist beispielsweise Glas oder Quarz.

Die Strahlungsschilde des erfindungsgemäßen NMR-Probenkopfes könnten theoretisch als koaxial um das Raumtemperaturrohr herumlaufende Rohre ausgeführt sein. Jedoch dürfte das Rohrmaterial in der Regel eine zu große Dicke aufweisen.

Möglich ist auch der Aufbau der Strahlungsschilde aus einer unidirektionalen Folie, deren Herstellung und Verarbeitung allerdings relativ schwierig ist. Die Ausrichtung der Folie längs der z-Achse kann beispielsweise durch Anwendung mechanischer Zugspannung hergestellt werden.

Bevorzugt ist demgegenüber eine Ausführungsform, bei der die Strahlungsschilde aus einem unidirektionalen Gewebe aufgebaut sind.

Derartige unidirektionale Gewebe aus entsprechend geeigneten Materialien sind ohne weiteres im Handel erhältlich.

Bevorzugt bestehen diese Gewebe aus Fasermatten, insbesondere Glasfasermatten, die aus Fasern mit Durchmessern von weniger als $10 \mu m$ aufgebaut sind und insgesamt eine Dicke von etwa 30 um aufweisen. Anstelle einer radialen Abfolge von zylindrischen Einzel-Strahlungsschilden kann bei der Verwendung von derartigen Glasfasermatten auch an ein schneckenförmiges Umwickeln des Raumtemperaturrohres auf seiner Vakuumseite in mehreren Lagen gedacht werden.

Bei einer weiteren besonders bevorzugten Ausführungsform sind die Strahlungsschilde aus in z-Richtung ausgerichteten, radial um die Achse des Raumtemperaturrohres angeordneten Stäben oder Fasern, vorzugsweise Glasfasern und/oder Quarzfasern aufgebaut. Derartige Fasern sind mit Durchmessern zwischen 10 und 50 $\mu m$ im Handel erhältlich. Es gibt allerdings auch Glasfilamente mit Durchmessern von weniger als $5 \mu m$, die allerdings schwierig zu verarbeiten sein dürften.

Bei einer vorteilhaften Weiterbildung sind die Strahlungsschilde aus Faserbündeln aufgebaut, die insgesamt dann wieder eine etwas höhere mechanische Stabilität als die Einzelfilamente aufweisen und daher bei ihrer Verarbeitung ähnlich wie Stäbe einfacher zu handhaben sind.

Die Stäbe oder Fasern können bei Ausführungsformen lose im Raum angeordnet und nur an ihren Enden befestigt sein.

Alternativ können die Stäbe oder Fasern aber auch an einem zum Raumtemperaturrohr koaxial angeordneten Trägerrohr, vorzugsweise an der dem HF-Empfangsspulensystem zugewandten Seite des Raumtemperaturrohres selbst befestigt sein.

Bei einer bevorzugten Weiterbildung sind die Stäbe oder Fasern am Trägerrohr bzw. am Raumtemperaturrohr mit einem für HF-Strahlung transparenten Klebstoff befestigt, so daß keine Dämpfung der HF-Strahlung von der Meßprobe zu der HF-Empfangsspule aufgrund der Verklebung erfolgt.

Vorteilhaft ist auch eine Weiterbildung, bei der die Stäbe oder Fasern in Umfangsrichtung um die Achse des Raumtemperaturrohres herum dicht gepackt angeordnet sind, so daß in radialer Richtung kein "optischer Durchblick" besteht. Auf diese Weise bilden die Stäbe oder Fasern jeweils einen in Umfangsrichtung zusammenhängenden Strahlungsschild.

Besonders bevorzugt ist auch eine Ausführungsform des erfindungsgemäßen NMR-Probenkopfes, bei der eine Zentriervorrichtung zur Zentrierung des Probenröhrchens in Meßposition um die Achse des Raumtemperaturrohres vorgesehen ist. Die Quertemperaturgradienten radial zur z-Achse, die beim Betrieb eines gekühlten NMR-Probenkopfes auftreten können, ergeben sich nämlich als Produkt aus dem Wärmeverlust pro Flächeneinheit, dem Reziprokwert des Massenstromes von Temperiergas und einem Symmetriefaktor, welcher einen Versatz oder eine Winkelabweichung der Achse des Probenröhrchens von der z-Achse des Raumtemperaturrohres beinhaltet. Da diese Asymmetrie als Faktor in das gesamte Produkt eingeht, ergeben sich auch bei kleinen Schrägstellungen der Meßprobe innerhalb des Raumtemperaturrohres erhebliche Einflüsse auf den Temperierungsfluß. Daher kann mit der vorgeschlagenen Zentriervorrichtung ein nicht zu vernachlässigender, zusätzlicher Effekt im Sinne einer Verringerung der Temperaturgradienten und einer Verbesserung der Qualität der NMR-Signale bewirkt werden.

Bei einer besonders einfach realisierbaren Weiterbildung umfaßt die Zentriervorrichtung einen oder mehrere zwischen dem Raumtemperaturrohr und dem Probenröhrchen angeordnete symmetrisch um die z-Achse des Raumtemperaturrohres verteilte Abstandhalter.

Diese Abstandhalter können im Bereich des Bodens des Probenröhrchens in dessen Meßposition und/oder im Bereich der Einfüllöffnung des Raumtemperaturrohres an der dem Probenröhrchen zugewandten Seite des Raumtemperaturrohres angebracht sein. Alternativ können sich die Abstandhalter aber auch über die gesamte axiale Länge des HF-Empfangsspulensystems erstrecken.

Vorteilhaft ist auch eine Weiterbildung, bei der die Abstandhalter aus in Richtung der z-Achse ausgedehnten Streifen aus federndem Material bestehen, die an ihrem dem Probengläschen in dessen Meßposition abgewandten Ende starr mit dem Raumtemperaturrohr verbunden sind, und die an ihrem dem Probengläschen in dessen Meßposition zugewandten Ende eine zum Probengläschen hin ausgebauchte Sicke aufweisen, deren freier Schenkel am Raumtemperaturrohr anliegt.

Um die NMR-Messungen nicht zu stören, sollten die Abstandhalter aus einem für die HF-Strahlung transparenten Material aufgebaut sein.

Bei einer bevorzugten Weiterbildung bestehen die Abstandhalter aus Blechstreifen mit einer Dicke von etwa 100μm und einer Breite quer zur z-Achse von etwa 0,5mm bis 2mm, vorzugsweise etwa 1 mm.

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:

Fig. 1    einen schematischen Vertikalschnitt längs der z-Achse durch einen erfindungsgemäßen NMR-Probenkopf im Bereich des HF-Empfangsspulensystems;

Fig. 2    einen schematischen Horizontalschnitt durch einen erfindungsgemäßen NMR-Probenkopf im axialen Bereich des HF-Empfangsspulensystems;

Fig. 3    einen schematischen Vertikalschnitt durch einen gekühlten NMR-Probenkopf nach dem Stand der Technik mit zugehörigem Temperaturverlauf in Richtung der z-Achse;

Fig. 4a    einen schematischen Horizontalschnitt durch eine Anordnung mit asymmetrisch in das Raumtemperaturrohr eingeführtem Probenröhrchen;

Fig. 4b    die zur Anordnung nach Fig. 4a zugehörige Temperaturverteilung in z-Richtung;

Fig. 5a    einen schematischen Vertikalschnitt durch ein Raumtemperaturrohr mit asymmetrisch eingeführtem Probenröhrchen und angedeuteten Konvektionsströmungen innerhalb der Meßprobe;

Fig. 5b    die zugehörigen Temperaturverläufe in Richtung der z-Achse auf der linken und der rechten Seite der Anordnung von Fig. 5a;

Fig. 6    ein Schema des Temperaturverlaufs des Temperiergases in Richtung der z-Achse bei asymmetrisch in das Raumtemperaturrohr eingeführtem Probenröhrchen und einer gut wärmeleitenden Innenseite des Raumtemperaturrohres im Bereich der HF-Empfangsspulen;

Fig. 7    einen schematischen Temperaturverlauf in Richtung der z-Achse bei gut wärmeleitender Innenseite des Raumtemperaturrohres;

Fig. 8a     eine schematische Darstellung der Wärmeflüsse aufgrund von Strahlung zwischen einer Fläche auf Temperatur $T_1$ und einer zweiten Fläche auf Temperatur $T_2$;

Fig. 8b     wie Fig. 8a, jedoch mit einem Strahlungsschild auf Temperatur $T_3$ zwischen den beiden Flächen;

Fig. 9a     den Wärmefluß zwischen den Flächen nach Fig. 8a auf einer $T^4$-Skala;

Fig. 9b     die Situation der Anordnung nach Fig. 8b auf einer $T^4$-Skala;

Fig. 9c     wie Fig. 9b, jedoch statt mit einem Strahlungsschild mit vier zwischengeschalteten Strahlungsschilden;

Fig.10a     eine schematische Darstellung der Magnetfeldbeeinträchtigung durch Verwendung von Materialien mit magnetischer Suszeptibilität > 0;

Fig.10b     wie Fig. 10a, jedoch mit in z-Richtung längs des Magnetfeldes ausgedehntem Objekt;

Fig.11a     einen schematischen Vertikalschnitt durch eine erfindungsgemäße Anordnung mit Zentriervorrichtung; und

Fig.11b     einen Horizontalschnitt durch eine Anordnung nach Fig.11a.

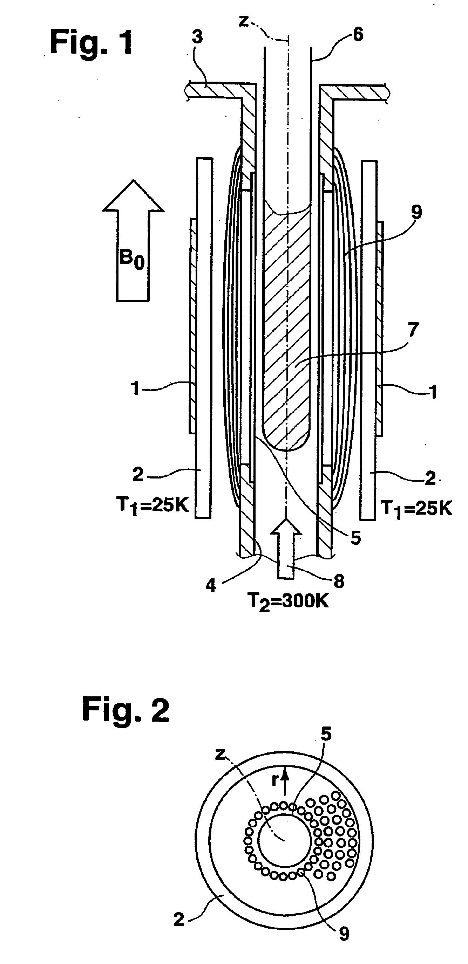

Der in Fig. 1 schematisch dargestellte NMR-Probenkopf weist ein HF-Empfangsspulensystem 1 auf, welches symmetrisch zu einer z-Achse um ein axial verlaufendes Raumtemperaturrohr 4 angeordnet ist, welches zur Aufnahme eines Probenröhrchens 6 dient, das eine Probensubstanz 7 enthält, die mit Hilfe von NMR-Messungen untersucht werden soll.

Das HF-Empfangsspulensystem 1 ist auf Wärmeleitungselementen 2 aufmontiert, die zur Kühlung des HF-Empfangsspulensystems 1 auf kryogene Temperaturen, in der Regel $T_1 \approx 25$ K dienen.

Das Raumtemperaturrohr 4 ist in seinem oberen und unteren Abschnitt mit einem Gehäuse 3 des NMR-Probenkopfes verbunden, während es in seinem mittleren Abschnitt ein für HF-Felder durchlässiges Innenrohr 5 (meist aus Glas) aufweist. Das axial in das Raumtemperaturrohr 4 ragende Probenröhrchen 6 wird mittels eines Gasstromes 8, der ungefähr auf Zimmertemperatur $T_2 = 300$ K temperiert ist, während der Messungen auf der gewünschten Temperatur gehalten.

Wie aus den Figuren 1 und 2 deutlich wird, sind zwischen dem Empfangsspulensystem 1 und dem Raumtemperaturrohr 4 mehrere Strahlungsschilde 9 angeordnet, die das Raumtemperaturrohr 4 in radialer Richtung umgeben und längs der z-Achse ausgedehnt sind. Die Strahlungsschilde 9 sind aus in z-Richtung ausgerichteten Materialien aufgebaut, welche für HF-Felder nahezu vollständig transparent sind. In radialer Richtung sind die Strahlungsschilde 9 voneinander beabstandet und berühren sich nicht oder zumindest nur punktuell bzw. linienförmig, wie in Fig. 2 gut erkennbar ist. Sie weisen eine radiale Dicke < 0,1 mm, vorzugsweise < 50 μm auf. Als bevorzugtes Material für die Strahlungsschilde 9 wird Glas oder Quarz verwendet.

Um die erfindungsgemäß geforderte Ausrichtung des Materials in z-Richtung zu erreichen, können die Strahlungsschilde 9 aus einer unidirektionalen Folie, aus unidirektionalem Gewebe, insbesondere aus Glasfasermatten oder aus axial verlaufenden Stäben oder Fasern, vorzugsweise Glas- oder Quarzfasern oder Faserbündeln aufgebaut sein.

Die Strahlungsschilde 9 können lose im Raum angeordnet und nur an ihren Enden befestigt oder, wie im gezeigten Ausführungsbeispiel am Raumtemperaturrohr 4 befestigt sein.

Im folgenden soll die Wirkungsweise der erfindungsgemäßen Anordnung erläutert werden:

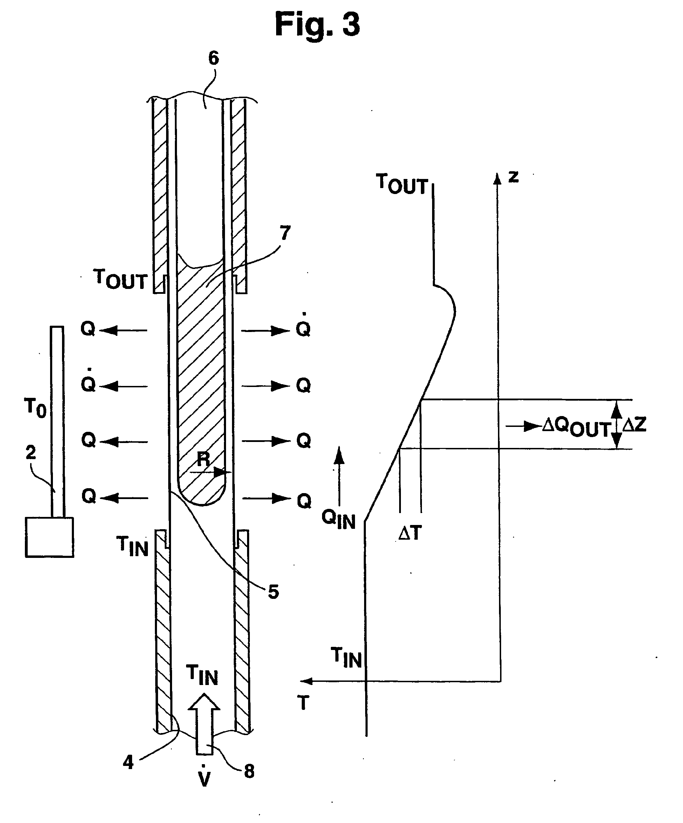

In Fig. 3 ist schematisch ein Ausschnitt aus einem NMR-Probenkopf nach dem Stand der Technik gezeigt, bei dem vom Probenröhrchen 6 radial in Richtung auf das HF-Empfangsspulensystem 1 durch Strahlung Wärmeströme Q abgehen, da das Empfangsspulensystem 1 auf einer kryogenen Temperatur von ungefähr 25 K gehalten wird, während das Probenröhrchen 6 mit Hilfe des von unten her zugeführten temperierten Luftstroms 8 ungefähr auf Zimmertemperatur gehalten werden soll. Durch die Wärmeabstrahlung aus dem Probenröhrchen 6 ergibt sich unter Berücksichtigung der mit dem Temperierstrom 8 zugeführten Wärme ein Temperaturverlauf in axialer Richtung innerhalb des Probenröhrchens 6, wie er auf der rechten Seite von Fig. 3 schematisch gezeigt ist.

Die relativ hohen Temperaturgradienten innerhalb der Probensubstanz 7 führen regelmäßig zu einer unerwünschten Verschlechterung der aufgenommenen NMR-Spektren. Es ergeben sich Linienverbreiterungen aufgrund der Temperaturabhängigkeit der chemischen Verschiebung, was dazu führen kann, daß zwei Substanzen nicht gleichzeitig geshimt werden können. Dieser Effekt ist insbesondere bei Wasser ausgeprägt.

Daneben können, wenn der Temperaturgradient einen kritischen Wert überschritten hat, Konvektionseffekte auftreten. Die sich dabei ergebenden Fluktuationen können die Stabilität beim Shimen und bei den NMR-Experimenten erheblich stören.

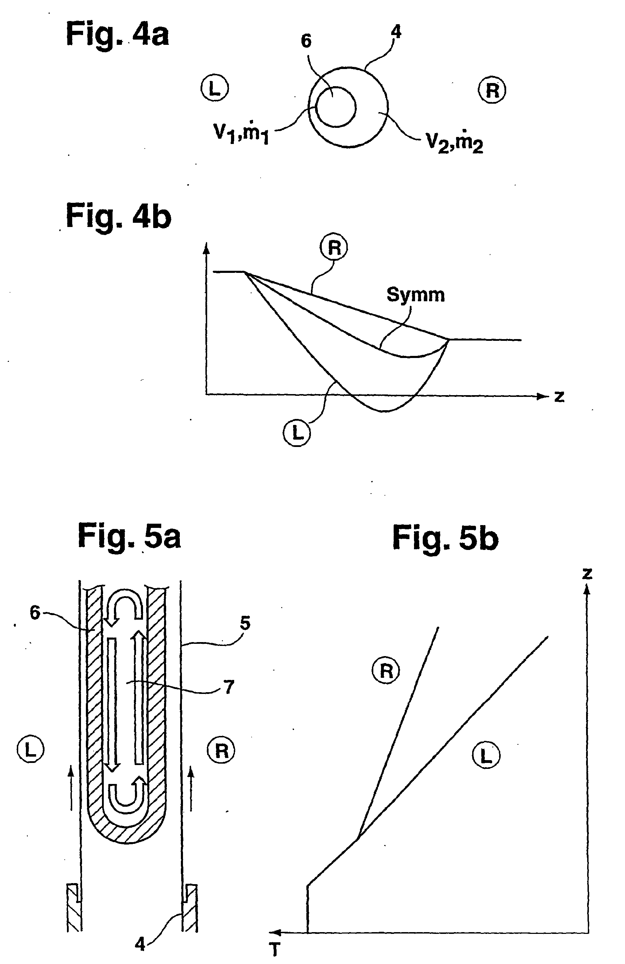

Neben den Temperaturgradienten in z-Richtung können auch transversale Gradienten auftreten, wenn das Probenröhrchen 6 nicht exakt in der Mitte des Raumtemperaturrohres 4 plaziert ist, wie in Fig. 4a in einem Horizontalschnitt schematisch dargestellt.

Durch die unterschiedlichen Massenflüsse, die sich aus den unterschiedlichen Strömungswiderständen auf der linken (L) und der rechten (R) Seite ergeben, treten verschiedene Längsgradienten auf beiden Seiten auf. Dies führt zu einem transversalen Temperaturgradienten, der nach oben hin immer ausgeprägter wird, wie in Fig. 4b dargestellt. Der mittlere der drei gezeigten Temperaturverläufe stellt den symmetrischen Fall dar.

Dieser Gradient begünstigt die Ausbildung einer Konvektion innerhalb der in der Regel flüssigen Probensubstanz 7 zusätzlich. Diese Situation ist in Fig. 5a schematisch dargestellt. Die zugehörigen Temperaturverläufe in z-Richtung sind in Fig. 5b gezeigt. Der Temperaturverlauf auf der rechten Seite (= R) kann dabei ganz erheblich von dem Temperaturverlauf auf der linken Seite (= L) differieren.

Um diesem Effekt entgegenzuwirken, wird der Mittelteil 5 des Raumtemperaturrohres 4 aus gut wärmeleitendem Material ausgeführt. Damit können die transversalen Temperaturgradienten (x-y-Richtung) stark vermindert werden. Es kommen allerdings nur Materialien in Frage, deren Absorption für HF-Strahlung vernachlässigbar gering ist und die gleichzeitig die geforderte hohe Wärmeleitfähigkeit haben. Konkret bietet sich hier Saphir als Material an.

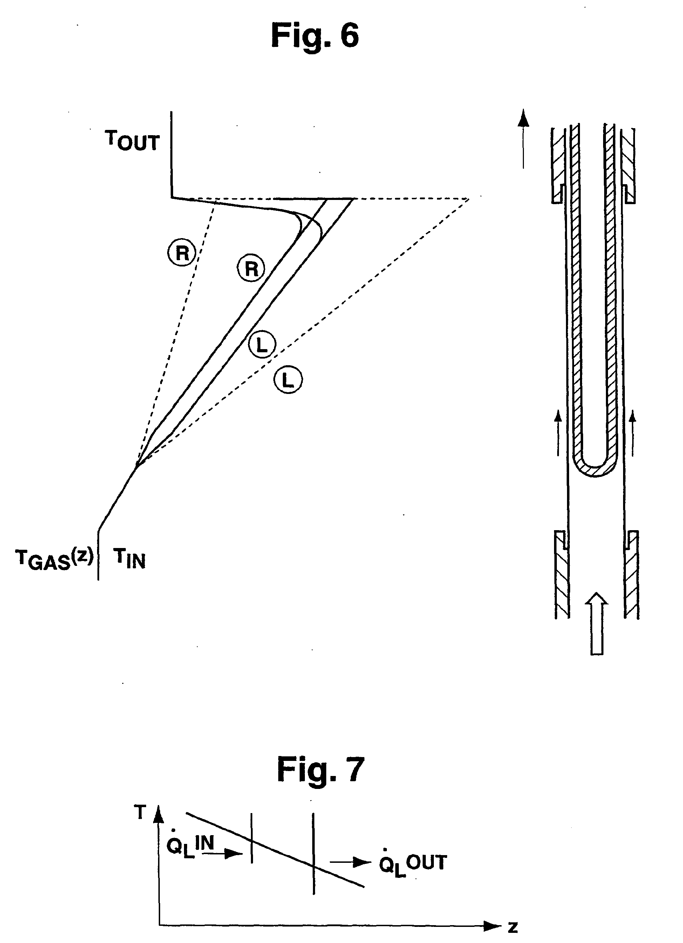

In Fig. 6 ist die Situation ohne gute Wärmeleitung (gestrichelt) und mit guter Wärmeleitung (durchgezogen) des Raumtemperaturrohres 4, insbesondere des Innenrohres 5 dargestellt. Der Temperaturverlauf längs der z-Achse läßt sich (abgesehen von einer Mittelung der beiden Extreme) damit aber praktisch nicht beeinflussen.

Lediglich der Temperaturverlauf kurz vor dem oberen Einspannpunkt des Probenröhrchens 6 läßt sich anheben. Ein linearer Temperaturgradient kann durch wärmeleitende Maßnahmen am Raumtemperaturrohr 4 alleine nicht beseitigt werden, wie der in Fig. 7 gezeigte schematische Temperaturverlauf in Richtung der z-Achse bei einer gut wärmeleitenden Innenseite des Raumtemperaturrohres 4 deutlich macht.

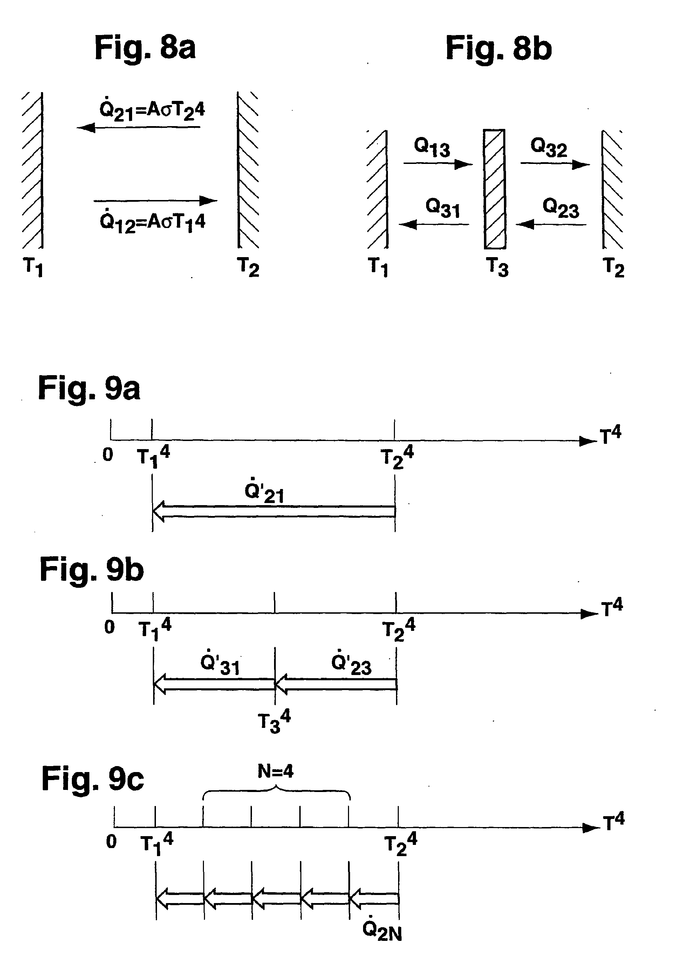

Um die Wärmestrahlungsflüsse zwischen dem Probenröhrchen 4 und dem gekühlten HF-Empfangsspulensystem 1 näher zu untersuchen, ist in Fig. 8a schematisch die Strahlungsleistung zwischen einer Fläche $F_1$ auf einer Temperatur $T_1$ und einer gegenüberliegenden Fläche $F_2$ auf einer Temperatur $T_2$ dargestellt. Die Strahlungsleistung einer Fläche $F_1$ zur Fläche $F_2$ beträgt

$$Q_{1\,2} = A \times \sigma \times T_1^4 \times \varepsilon,$$

die Strahlungsleistung in umgekehrter Richtung

$$Q_{2\,1} = A \times \sigma \times T_2^4 \times \varepsilon.$$

Dabei bedeuten A die Größe der abstrahlenden Flächen, $\sigma$ den spezifischen Wärmefluß (ungefähr gleich $5{,}77 \times 10^{-8}$ W/m$^2$ K$^4$) und den Strahlungskoeffizienten, der sich zwischen 0 und 1 bewegen kann. Für den Fall, daß zwei vollkommen schwarze Körper vorliegen, die keine auftreffende Strahlung reflektieren, gilt $\varepsilon = 1$.

Die Netto-Kühlleistung $Q_2$ an der Fläche $F_2$ bei $\varepsilon = 1$ beträgt

$$Q_2 = Q_{2\,1} - Q_{1\,2} = A \times \sigma \times (T_2^4 - T_1^4).$$

Führt man nun zwischen die beiden Flächen $F_1$ und $F_2$ einen schwarzen Strahlungsschild $F_3$ ein, der ohne jeglichen direkten Wärmekontakt zu den beiden anderen Flächen $F_1$ und $F_2$ steht, so stellt sich dort aufgrund der Strahlungsfelder eine Temperatur $T_3$ als Gleichgewicht ein, wie in Fig. 8b angedeutet.

Trägt man auf einer $T^4$-Skala die Temperaturen der verschiedenen Flächen ein, so sind die Wärmeflüsse zwischen den Flächen proportional zu den Differenzabständen $\Delta (T^4)$. Dies ist in Fig. 9a für den in Fig. 8a gezeigten Fall mit lediglich zwei Flächen und in Fig. 9b für den in Fig. 8b dargestellten Fall mit einem Strahlungsschild zwischen den beiden Flächen gezeigt. Als Gleichgewichtsbedingung für die Temperatur $T_3$ des Strahlungsschildes $F_3$ ist zu fordern, daß die beiden Netto-Wärmeflüsse $Q'_{23}$ zwischen der Fläche $F_2$ und dem Strahlungsschild $F_3$ und $Q'_{31}$ zwischen dem Strahlungsschild $F_3$ und der Fläche $F_1$ gleich sind.

Damit wurde aber durch das Zwischenschieben des Strahlungsschildes $F_3$ zwischen die beiden Flächen $F_1$ und $F_2$ die Temperaturdifferenz $\Delta(T_2^4-T_3^4) = \Delta(T_3^4 T_1^4)$ auf den halben Wert der in Fig. 9a gezeigten Temperaturdifferenz $\Delta(T_2^4 T_1^4)$ gebracht, da gelten muß:

$$Q'_{2\,3} = Q'_{3\,1} = 0{,}5 \times Q_{2\,1}.$$

In Fig. 9c ist nur eine Verallgemeinerung der in Fig. 9b dargestellten Situation auf N Strahlungsschilde gezeigt, die bei der Verwirklichung der Erfindung jeweils radial bezüglich der z-Achse hintereinander angeordnet sein sollen.

Analog zu dem in Fig. 9b behandelten Fall gilt allgemein:

$$Q_{2N} = (N+1)^{-1} \times Q_{2\,1}.$$

Dies bedeutet, daß bei Verwendung von N schwarzen Strahlungsschilden, die von der Fläche $F_2$ abgehende Netto-Strahlungsleistung auf $(N+1)^{-1}$ reduziert wird.

Beim Einsatz der erfindungsgemäßen Strahlungsschilde 9 ist weiterhin zu beachten, daß in der Anwendung für NMR-Messungen eine wichtige Grundvoraussetzung darin besteht, daß die Homogenität des statischen Magnetfeldes $B_0$ nicht beeinträchtigt werden darf. Alle magnetischen Objekte, die eine Variation ihrer magnetischen Eigenschaften in z-Richtung aufweisen, verursachen potentielle Störungen des $B_0$-Feldes.

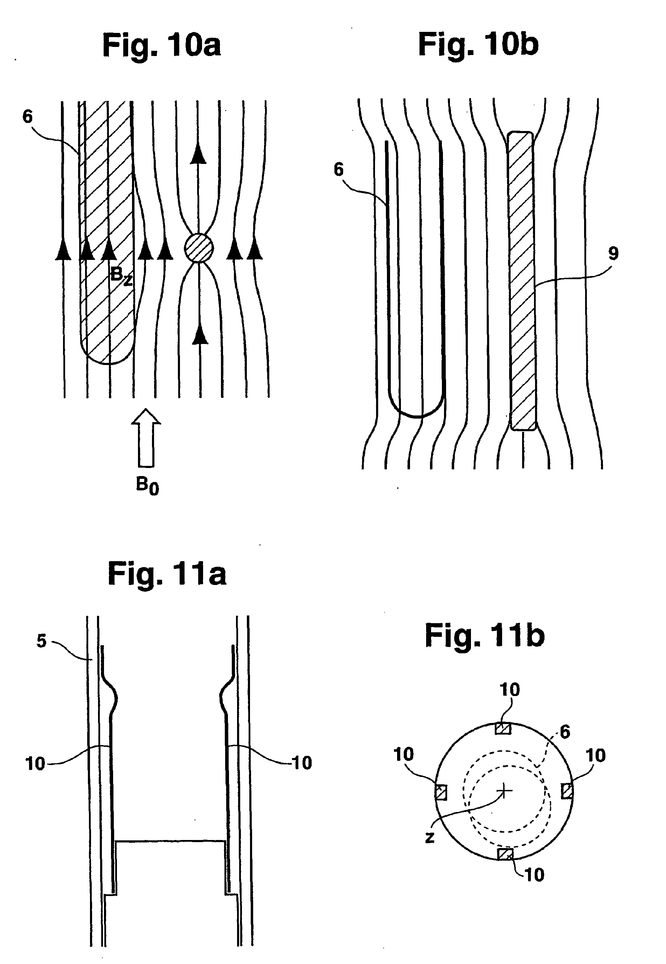

Die Situation einer solchen Feldbeeinträchtigung durch Verwendung von Materialien mit einer magnetischen Susceptibilität $\chi > 0$ ist schematisch in Fig. 10a dargestellt. Durch die magnetische Störung werden die Feldlinien des homogenen Magnetfeldes in einem gewissen Raumbereich verzerrt.

Fig. 10b hingegen stellt schematisch die erfindungsgemäße Situation dar, bei der ein Strahlungsschild 9 in z-Richtung längs des $B_0$-Feldes ausgedehnt ist und daher trotz einer magnetischen Susceptibilität $\chi > 0$ im entscheidenden Bereich der Meßprobe 7 keine Feldstörungen verursachen.

Die Figuren 11 a und 11b zeigen eine bevorzugte Ausführungsform des erfindungsgemäßen NMR-Probenkopfes mit einer Zentriervorrichtung, die im gezeigten Ausführungsbeispiel vier symmetrisch um die z-Achse verteilte Abstandhalter 10 umfaßt. Durch eine damit bewirkte saubere Zentrierung des Probenröhrchens 6 innerhalb des Raumtemperaturrohres 4 können, wie bereits oben erläutert, Konvektionsströme und damit die Bildung von Temperaturgradienten innerhalb der Probensubstanz 7 vermieden werden.

## Patentansprüche

1. NMR-Probenkopfvorrichtung

   - mit einem auf kryogene Temperaturen abkühlbaren HF-Empfangsspulensystem (1)
   - und einem in einer z-Richtung verlaufenden Raumtemperaturrohr (4) zur Aufnahme eines Probenröhrchens (6) längs der z-Richtung, welches mittels NMR-Messung zu untersuchende Probensubstanz (7) enthält,
   - sowie mit einer Vorrichtung zur Temperierung eines durch das Raumtemperaturrohr dem Probenröhrchen von unten her zugeführten, ungefähr auf Raumtemperatur gehaltenen Luftstroms (8),

   **dadurch gekennzeichnet, dass**

   - dass in einem Vakuum zwischen dem radial ausserhalb des Raumtemperaturrohrs angeordneten HF-Empfangsspulensystem (1) und dem Raumtemperaturrohr, im axialen Bereich des Empfangsspulensystems, mindestens ein das Raumtemperaturrohr in azimutaler Richtung umgebender, in z-Richtung ausgedehnter, auf der radial inneren und der radial äusseren Seite dem Vakuum ausgesetzter Strahlungsschild (9) angeordnet ist, welcher entweder (i) aus in z-Richtung ausgerichteten, koaxial um das Raumtemperaturrohr herumlaufenden Rohren, oder (ii) aus einer in z-Richtung unidirektional verstreckten Folie, oder (iii) einem in z-Richtung unidirektionalen Gewebe, oder (iv) in z-Richtung ausgerichteten Stäben oder Fasern, vorzugsweise Glasfasern und/oder Quarzfasern, besteht,
   - wobei das Material/die Materialien, aus denen der Strahlungsschild besteht, eine Absorption kleiner als 5% für HF-Felder aufweist/aufweisen.

2. NMR-Probenkopfvorrichtung nach Anspruch 1, **dadurch gekennzeichnet, dass** zwischen dem HF-Empfangsspulensystem (1) und dem Raumtemperaturrohr (4) N Strahlungsschilde (9) vom Typ (ii), (iii) oder (iv) in radialer Aufeinanderfolge angeordnet sind, wobei $N \geq 2$, vorzugsweise $5 \leq N < 25$, und dass die N Strahlungsschilde in radialer Richtung voneinander beabstandet sind und sich nicht, oder zumindest nur punktuell bzw. linienförmig, berühren.

3. NMR-Probenkopfvorrichtung nach einem der vorhergehenden Ansprüche, **dadurch gekennzeichnet, dass** die Strahlungsschilde aus Material aufgebaut sind, welches Strahlung in einem Wellenlängenbereich $10\mu m \leq \lambda \leq 100\mu m$ absorbiert oder reflektiert, und welches für Strahlung in einem Wellenlängenbereich $\lambda > 100mm$ transparent ist.

4. NMR Probenkopfvorrichtung nach einem der vorhergehenden Ansprüche, **dadurch gekennzeichnet, dass** eine Zentriervorrichtung zur Zentrierung des Probenröhrchens (6) in Messposition um die Achse des Raumtemperaturrohres (4) vorgesehen ist, und dass die Zentriervorrichtung einen oder mehrere zwischen dem Raumtemperaturrohr und dem Probenröhrchen angeordnete, symmetrisch um die z-Achse des Raumtemperaturrohres verteilte Abstandshalter (10) umfasst.

## Claims

1. NMR probe head device comprising

   - an RF receiver coil system (1), which can be cooled down to cryogenic temperatures,
   - a room temperature pipe (4) extending along a z direction for receiving a sample tube (6) along the z direction, which contains a sample substance (7) to be examined by NMR measurements, and
   - a device for tempering an air flow (8) which is kept approximately at room temperature and is supplied from below to the sample tube through the room temperature pipe,

**characterized in that**,

- in a vacuum between the RF receiver coil system (1), disposed radially outside of the room temperature pipe, and the room temperature pipe, at least one radiation shield (9), surrounding the room temperature pipe in the azimuthal direction, extending along the z direction, and being exposed to the vacuum on the radially inner and the radially outer sides, is disposed in the axial area of the receiver coil system, and consists either (i) of pipes oriented in the z direction and extending coaxially around the room temperature pipe, or (ii) of a foil stretched unidirectionally in the z direction or (iii) of a fabric which is unidirectional in the z direction, or (iv) of rods or fibers, preferably glass fibers and/or quartz fibers, which are oriented in the z direction,
- wherein the material or materials, of which the radiation shield consists, exhibit/s an absorption for RF fields of less than 5%.

**2.** NMR probe head device according to claim 1, **characterized in that** N radiation shields (9) of type (ii), (iii) or (iv) are disposed in radial sequence between the RF receiver coil system (1) and the room temperature pipe (4), wherein N≥2, preferably 5≤N<25 and that the N radiation shields are spaced apart from one another in a radial direction and do not contact each other or at the most have point or linear contact.

**3.** NMR probe head device according to any one of the preceding claims, **characterized in that** the radiation shields are formed of a material which absorbs or reflects radiation in a wavelength range of $10\mu m \le \lambda \le 100\mu m$ and which is transparent to radiation in a wavelength range of $\lambda > 100mm$.

**4.** NMR probe head device according to any one of the preceding claims, **characterized in that** a centering device is provided for centering the sample tube (6) in its measuring position about the axis of the room temperature pipe (4), and **in that** the centering device comprises one or more spacers (10) which are disposed between the room temperature pipe and the sample tube and distributed symmetrically about the z axis of the room temperature pipe.

**Revendications**

**1.** Tête de mesure RMN

- comprenant un système de bobines de réception HF (1) pouvant être refroidi à des températures cryogéniques
- et un tube à température ambiante (4) s'étendant dans une direction z et servant à recevoir un tube à essai (6) le long de la direction z, lequel contient une substance d'essai (7) à analyser au moyen d'une mesure RMN,
- ainsi que comprenant un dispositif pour l'équilibrage de la température d'un courant d'air (8) amené par le bas au tube à essai à travers le tube à température ambiante et maintenu approximativement à température ambiante,

**caractérisée en ce que**

- au moins un écran anti-rayonnement (9) entourant le tube à température ambiante en direction azimutale, allongé en direction z, exposé au vide du côté radialement intérieur et du côté radialement extérieur est disposé dans la zone axiale du système de bobines de réception, dans un vide entre le système de bobines de réception HF (1) disposé radialement à l'extérieur du tube à température ambiante et le tube à température ambiante, lequel écran anti-rayonnement est constitué soit (i) de tubes orientés en direction z, faisant le tour coaxialement du tube à température ambiante, soit (ii) d'une feuille étirée unidirectionnellement en direction z, soit (iii) d'un tissu unidirectionnel en direction z, soit (iv) de barreaux ou de fibres orientés en direction z, de préférence de fibres de verre et/ou de fibres de quartz,
- le matériau/les matériaux dont est constitué l'écran anti-rayonnement présentant une absorption inférieure à 5 % pour les champs HF.

**2.** Tête de mesure RMN selon la revendication 1, **caractérisée en ce que** N écrans anti-rayonnement (9) du type (ii), (iii) ou (iv) sont disposés en succession radiale entre le système de bobines de réception HF (1) et le tube à température ambiante (4), sachant que N ≥ 2, de préférence 5 ≤ N < 25, et que les N écrans anti-rayonnement sont espacés les uns des autres en direction radiale et ne se touchent pas ou au moins seulement ponctuellement ou linéairement.

**3.** Tête de mesure RMN selon l'une des revendications précédentes, **caractérisée en ce que** les écrans anti-rayonnement sont constitués d'un matériau qui absorbe ou réfléchit le rayonnement dans une plage de longueurs d'onde $10 \, \mu m \le \lambda \le 100 \, \mu m$ et qui est transparent au rayonnement dans une plage de longueurs d'onde $\lambda > 100 \, mm$.

**4.** Tête de mesure RMN selon l'une des revendications précédentes, **caractérisée en ce qu'**il est prévu un dispositif de centrage pour centrer le tube à essai (6) en position de mesure autour de l'axe du tube à température ambiante (4), et que le dispositif de centrage comprend une ou plusieurs pièces d'écartement (10) disposées entre le tube à température ambiante et le tube à essai, réparties symétriquement autour de l'axe z du tube à température ambiante.

# Fig. 1

# Fig. 2

# Fig. 3

# Fig. 4a

$V_1, \dot{m}_1$    $V_2, \dot{m}_2$

# Fig. 4b

# Fig. 5a

# Fig. 5b

# Fig. 6

# Fig. 7

## Fig. 8a

$$\dot{Q}_{21} = A\sigma T_2^4$$

$$\dot{Q}_{12} = A\sigma T_1^4$$

$T_1$      $T_2$

## Fig. 8b

$Q_{13}$    $Q_{32}$

$Q_{31}$    $Q_{23}$

$T_1$     $T_3$     $T_2$

## Fig. 9a

$T^4$

$0$   $T_1^4$      $T_2^4$

$\dot{Q}'_{21}$

## Fig. 9b

$T^4$

$0$   $T_1^4$      $T_2^4$

$\dot{Q}'_{31}$     $\dot{Q}'_{23}$

$T_3^4$

## Fig. 9c

$N=4$

$T^4$

$0$   $T_1^4$      $T_2^4$

$\dot{Q}_{2N}$

14

# Fig. 10a

# Fig. 10b

# Fig. 11a

# Fig. 11b